# EUROPEAN PATENT APPLICATION

(11) **EP 4 746 021 A1**
(43) Date of publication of application: **20.05.2026**
(21) Application number: 24864993.1
(22) Date of filing: 21.05.2024
(51) Int. Cl.: H01J 37/244, C09K 11/62, H01J 43/04, H01J 49/02

(54) **LIGHT-EMITTING BODY, CHARGED PARTICLE DETECTOR, ELECTRON MICROSCOPE, AND MASS SPECTROMETER**

(30) Priority: 13.09.2023 JP 2023148567
(71) Applicant: Hamamatsu Photonics K.K., Hamamatsu-shi, Shizuoka 435-8558 (JP)
(72) Inventor: YAMAUCHI, Kuniyoshi, Hamamatsu-shi, Shizuoka 435-8558 (JP); MAEDA, Junya, Hamamatsu-shi, Shizuoka 435-8558 (JP); TAKAGI, Yutaka, Hamamatsu-shi, Shizuoka 435-8558 (JP); NAKAMURA, Tomohiro, Hamamatsu-shi, Shizuoka 435-8558 (JP); NAKAMURA, Takayuki, Hamamatsu-shi, Shizuoka 435-8558 (JP)
(74) Representative: Grünecker Patent- und Rechtsanwälte PartG mbB
(86) International application number: PCT/JP2024/018715
(87) International publication number: WO 2025/057485

(57) **Abstract**

A light-emitting body is a light-emitting body that converts incident charged particles into light and includes a multiple quantum well structure for emitting the light upon incidence of the charged particles. A thickness of a well layer constituting the multiple quantum well structure is equal to or greater than 0.2 nm and less than 1.5 nm. A concentration of an additive added in a barrier layer and the well layer constituting the multiple quantum well structure is higher than 4 × 10¹⁸ cm⁻³ and equal to or lower than 1 × 10²⁰ cm⁻³.

## Description

### Technical Field

An aspect of the present invention relates to a light-emitting body, a charged particle detector, an electron microscope, and a mass spectrometer.

### Background Art

Patent Literature 1 describes a light-emitting body that converts incident electrons into light. The light-emitting body described in Patent Literature 1 includes a substrate, a nitride semiconductor layer formed on one side of the substrate in a quantum well structure, a cap layer stacked on the nitride semiconductor layer and composed of a material having a greater band gap energy than the constituent materials of the nitride semiconductor layer, and a metal back layer formed on the cap layer.

### Citation List

### Patent Literature

[Patent Literature 1] Japanese Patent No. 4365255

### Summary of Invention

### Technical Problem

For the light-emitting body described above, it may be desirable to further enhance the high-speed responsiveness, for example, in order to capture events that occur in a shorter period of time. Thus, an aspect of the present invention aims to provide a light-emitting body, a charged particle detector, an electron microscope, and a mass spectrometer that can further enhance the high-speed responsiveness.

### Solution to Problem

The present inventors have studied the issue intensively and found that there is a correlation between a thickness of the well layers and an afterglow time in the light-emitting body. They have also found that there is a correlation between a concentration of an additive and an afterglow time in the light-emitting body, and that the greater the concentration of the additive, the shorter the afterglow time. On the other hand, they have found that, when the concentration of the additive is equal to or higher than a certain level, the light emission intensity drops significantly due to, for example, poor crystallinity, causing a difficulty in practical use. Thus, the present inventors further studied the issue and came to achieve an aspect of the present invention assuming that, if a thickness of the well layer and a concentration of additives in the barrier layer and the well layer can be optimized, it will be possible to shorten the afterglow time while maintaining the light emission intensity, thereby enhancing the high-speed responsiveness.

(1) That is, a light-emitting body in accordance with an aspect of the present invention is a light-emitting body that converts incident charged particles into light, the light-emitting body including a multiple quantum well structure for emitting the light upon incidence of the charged particles, in which a thickness of a well layer constituting the multiple quantum well structure is equal to or greater than 0.2 nm and less than 1.5 nm, and a concentration of an additive added in a barrier layer and the well layer constituting the multiple quantum well structure is higher than 4 × 10¹⁸ cm⁻³ and equal to or lower than 1 × 10²⁰ cm⁻³.

In the light-emitting body, the thickness of the well layer is equal to or greater than 0.2 nm and less than 1.5 nm, and the concentration of the additives in the barrier layer and the well layer is higher than 4 × 10¹⁸ cm⁻³ and equal to or lower than 1 × 10²⁰ cm⁻³. In this case, the thickness of the well layer and the concentration of the additives in the barrier layers and the well layers can be optimized based on the above-described findings to shorten the afterglow time while maintaining the light emission intensity. Therefore, the response time can be further shortened and the high-speed responsiveness can be further enhanced.

(2) In the light-emitting body described in (1) above, the thickness of the well layer may be equal to or greater than 0.6 nm and less than 1.0 nm. In this case, the afterglow time can be further shortened.

(3) In the light-emitting body described in (1) or (2) above, the multiple quantum well structure may be configured to include a first barrier layer and a second barrier layer as the barrier layers, the second barrier layer may be positioned on a charged particle-incident surface side of the multiple quantum well structure with respect to the first barrier layer, and the first barrier layer may be thicker than the second barrier layer. By varying the thickness of the barrier layer according to the distance from the charged particle-incident surface as described above, the light conversion efficiency can be improved across a range of low to high acceleration voltages, thereby increasing the light emission intensity.

(4) In the light-emitting body described in any one of (1) through (3) above, the well layer and the barrier layer may be nitride semiconductor layers, and the additive may include silicon. In this case, the well layer and the barrier layer are nitride semiconductor layers, and silicon can be used as the additive.

(5) A charged particle detector according to an aspect of the present invention includes the light-emitting body described in any one of (1) to (4) above, and a photodetector that is optically coupled to the side opposite to a charged particle-incident surface in the multiple quantum well structure and sensitive to light emitted by the multiple quantum well structure. The high-speed responsiveness can be further enhanced as well in this charged particle detector since the above-described light-emitting body is provided.

(6) An electron microscope according to an aspect of the present invention includes the light-emitting body described in any one of (1) to (4), a photodetector that is optically coupled to the side opposite to a charged particle-incident surface in the multiple quantum well structure and sensitive to the light emitted by the multiple quantum well structure, and a chamber in which at least the light-emitting body is placed, in which a surface of a sample placed in the chamber is irradiated with an electron beam, electrons from the sample are directed to the light-emitting body, and an image of the sample is acquired by associating the irradiation position of the electron beam on the sample with an output of the photodetector. The high-speed responsiveness can be further enhanced as well in this electron microscope since the above-described light-emitting body is provided.

(7) A mass spectrometer according to an aspect of the present invention includes the light-emitting body described in any one of (1) to (4), a photodetector that is optically coupled to the side opposite to a charged particle-incident surface in the multiple quantum well structure and sensitive to the light emitted by the multiple quantum well structure, a chamber in which at least the light-emitting body is placed, a separation unit that spatially or temporally separates ions generated from the sample in the chamber according to their mass, and an electron converter irradiated with ions separated by the separation unit, in which electrons emitted from the electron converter are directed to the light-emitting body in response to incidence of ions to the electron converter, and mass analysis of the sample is performed based on an output of the photodetector. The high-speed responsiveness can be further enhanced as well in this mass spectrometer since the above-described light-emitting body is provided.

### Advantageous Effects of Invention

Thus, according to an aspect of the present invention, a light-emitting body, a charged particle detector, an electron microscope, and a mass spectrometer that can further enhance the high-speed responsiveness can be provided.

### Brief Description of Drawings

FIG. 1 is a cross-sectional view of a configuration of a light-emitting body according to a first embodiment.
FIG. 2 is an enlarged cross-sectional view of an internal structure of the multiple quantum well structure of FIG. 1.
FIG. 3 is a graph showing the decay when the well layer thickness in the light-emitting body of FIG. 1 is varied.
FIG. 4 is a graph showing the decay when the concentration of additives in the light-emitting body of FIG. 1 is varied.
FIG. 5 is a graph showing the light emission intensity when the well layer thickness in the light-emitting body of FIG. 1 is varied.
FIG. 6 is a graph showing the light emission intensity when the concentration of additives in the light-emitting body of FIG. 1 is varied.
FIG. 7 is a graph showing a correlation between decay and light emission intensity in the light-emitting body of FIG. 1.
FIG. 8 is a cross-sectional view showing a configuration of an electron beam detector according to a second embodiment.
FIG. 9 is a view schematically illustrating a configuration of a metrology SEM according to a third embodiment.
FIG. 10 is a view schematically illustrating a configuration of a mass spectrometer according to a fourth embodiment.

### Description of Embodiments

Hereinafter, embodiments will be described in detail with reference to the drawings. In each of the drawings, redundant explanations will be omitted by assigning the same reference numerals to the same or corresponding parts.

### [First embodiment]

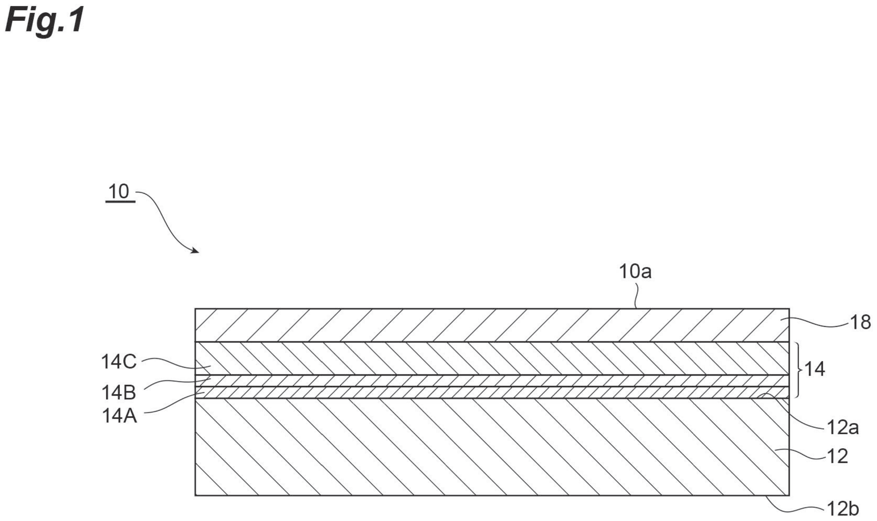

FIG. 1 is a cross-sectional view illustrating a configuration of a light-emitting body 10 according to a first embodiment. The light-emitting body 10 converts incident charged particles, which are electrons in this embodiment, into light. The light-emitting body 10 has a substrate 12, a nitride semiconductor layer 14 provided on a main surface 12a of the substrate 12, and a conductive layer 18 provided on the nitride semiconductor layer 14 as illustrated in FIG. 1. A surface of the conductive layer 18 constitutes an electron-incident surface (charged particle-incident surface) 10a.

The substrate 12 is a plate-like member that is light transmissive with respect to the wavelength of light emitted from the nitride semiconductor layer 14. Constituent materials of the substrate 12 are not particularly limited as long as the substrate transmits light emitted from the nitride semiconductor layer 14 and is suitable for epitaxial growth of the nitride semiconductor layer 14. In one example, the substrate 12 is a sapphire substrate. Further, in another example, the substrate 12 transmits light having a wavelength of 170 nm or longer. The substrate 12 has the main surface 12a and a back surface 12b that is positioned at the side opposite to the main surface 12a.

The nitride semiconductor layer 14 includes a first buffer layer 14A provided on the main surface 12a of the substrate 12, a second buffer layer 14B provided on the first buffer layer 14A, and a multiple quantum well structure 14C provided on the second buffer layer 14B.

The first buffer layer 14A is a layer for growing the multiple quantum well structure 14C with good crystallinity and is in contact with the main surface 12a. The first buffer layer 14A is grown at relatively low temperatures (e.g., between 400°C and 700°C) and has an amorphous structure containing mainly gallium (Ga) and nitrogen (N), for example. In one example, the first buffer layer 14A consists of amorphous GaN. The first buffer layer 14A has a thickness of, for example, 5 nm to 500 nm, and in one example, 20 nm.

The second buffer layer 14B is also a layer for growing the multiple quantum well structure 14C with good crystallinity and mainly contains GaN crystals, for example. In one example, the second buffer layer 14B consists of GaN crystals. The second buffer layer 14B is epitaxially grown at a higher temperature than the first buffer layer 14A (e.g., 700°C to 1200°C). The second buffer layer 14B has a thickness of, for example, 1 µm to 10 µm, and in one example, 2.5 µm. The second buffer layer 14B may be in contact with the first buffer layer 14A.

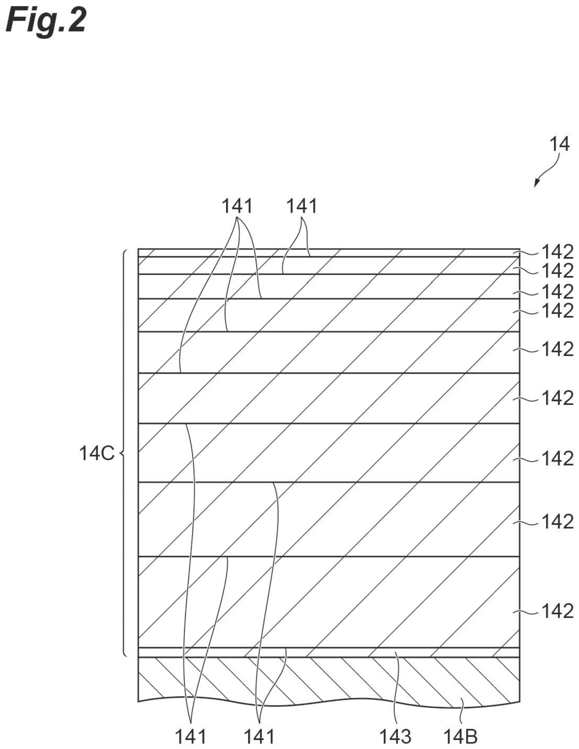

The multiple quantum well structure 14C is the part that emits light upon the incidence of electrons and is a layer epitaxially grown on the second buffer layer 14B. FIG. 2 is an enlarged cross-sectional view of an internal structure of the multiple quantum well structure 14C. The multiple quantum well structure 14C has a configuration in which well layers 141 and barrier layers 142 are alternately stacked as illustrated in FIG. 2.

The well layers 141 are light-emitting layers composed of a material that receives electrons to emit light. The well layers 141 are nitride semiconductor layer mainly containing InₓGa₁ - ₓN (0 < x < 1) crystal, for example. In one example, the well layers 141 consist of Si-doped InₓGa_{1 - x}N (0 < x < 1) crystal. When electrons enter the multiple quantum well structure 14C, pairs of electrons and holes are formed, which recombine in the well layers 141 to emit light (cathodoluminescence). The compositions of the multiple well layers 141 comprising the multiple quantum well structure 14C are identical to each other, and the above compositions x are equal to each other. In one example, the compositions x are 0.1. Further, the thicknesses of the multiple well layers 141 comprising the multiple quantum well structure 14C are equal to each other.

A bandgap energy of the barrier layers 142 is larger than that of the well layers 141. By sandwiching the well layers 141 between the barrier layers 142, electrons can be collected in the well layers 141 and efficiently converted to light. The barrier layers 142 are nitride semiconductor layers mainly containing GaN crystals. In one example, the barrier layers 142 consist of Si-doped GaN crystals. Note that the barrier layers 142 may further contain group III atoms other than Ga (e.g., In). In that case, the compositions of the multiple barrier layers 142 comprising the multiple quantum well structure 14C are equal to each other.

The thicknesses of the multiple barrier layers 142 comprising the multiple quantum well structure 14C are different from each other. Specifically, each barrier layer 142 is thicker than any barrier layer 142 positioned on the electron-incident surface 10a side (see FIG. 1) with respect to that barrier layer 142. In other words, the thicknesses of the multiple barrier layers 142 increase with distance from the electron-incident surface 10a, and the first barrier layer 142 closest to the electron-incident surface 10a is the thinnest among the multiple barrier layers 142. In a suitable example, the thickness of the first layer barrier layer 142 closest to the electron-incident surface 10a is equal to or less than 80% of the average thickness of the barrier layers 142, and more preferably equal to or less than 20%. The thickness of the second barrier layer 142 (i.e., the barrier layer 142 adjacent to the barrier layer 142 closest to the electron-incident surface 10a) is equal to or less than 90% of the average thickness of the multiple barrier layers 142, and more preferably equal to or less than 80%.

In the multiple quantum well structure 14C of the present embodiment, nine barrier layers 142 are provided. Counting from the electron-incident surface 10a side, the first well layer 141 is provided between the first and second barrier layers 142. Thereafter, the n-th (n = 2, ..., 8) well layer 141, counting from the electron-incident surface 10a side, is provided between the n-th barrier layer 142 and the (n + 1)-th barrier layer 142. Note that, a barrier layer 143 (see FIG. 2) having the same composition as each barrier layer 142 is provided between the last (ninth) well layer 141 and the second buffer layer 14B. Although not affecting characteristics of the light-emitting body 10, a thickness of the barrier layer 143 is, for example, 10 nm. Note that, if necessary, the barrier layer 143 may not be provided.

In this embodiment, with respect to all the multiple barrier layers 142, the thicknesses of the barrier layers 142 increase with distance from the electron-incident surface 10a, but if, for example, a majority of the numerous barrier layers 142 satisfy this condition, the effects of this embodiment are hardly impaired even if some of the barrier layers 142 do not satisfy this condition. That is, the effects of the present embodiment described below are suitably achieved when a certain barrier layer 142 (hereinafter referred to as a "first barrier layer") included in the multiple barrier layers 142 is thicker than another barrier layer 142 (hereinafter referred to as a "second barrier layer") positioned on the electron-incident surface 10a side with respect to the aforementioned barrier layer 142.

In the present embodiment, the difference in thickness between barrier layers 142 adjacent to each other decreases as distance from the electron-incident surface 10a increases. Note that, for example, if the majority of numerous barrier layers 142 meet this condition, the effects of this embodiment are hardly impaired even if some of the barrier layers 142 do not meet this condition. In other words, when the difference in thickness between a pair of barrier layers 142 adjacent to each other included in the multiple barrier layers 142 is smaller than the difference in thickness between another pair of barrier layers 142 adjacent to each other positioned closer to the electron-incident surface 10a side than the aforementioned pair of barrier layers 142, the effect described below can be suitably achieved.

The conductive layer 18 is used as one electrode that conducts electrons to the light-emitting body 10. The conductive layer 18, for example, mainly contains a metal, and in one embodiment, mainly contains aluminum (Al). The thickness of the conductive layer 18 is, for example, between 10 nm and 1000 nm, and in one embodiment, is about 300 nm. If the conductive layer 18 mainly contains a metal, the conductive layer 18 also functions as an optical reflective film. In other words, while some of light generated in the multiple quantum well structure 14C reaches the substrate 12 directly from the multiple quantum well structure 14C, transmits the substrate 12, and is emitted outside the light-emitting body 10, the remainder of the light generated in the multiple quantum well structure 14C reaches the conductive layer 18 from the multiple quantum well structure 14C, is reflected on the conductive layer 18, and transmits the substrate 12 to be emitted to the outside the light-emitting body 10.

An example of a method for manufacturing the light-emitting body 10 will be described. First, the substrate 12 is introduced into the growth chamber of a Metal-Organic Vapor Phase Epitaxy (MOVPE) apparatus, and thermal treatment is performed in a hydrogen atmosphere at 1100°C for 10 minutes to clean the main surface 12a. Then, the temperature of the substrate 12 is lowered to 500°C to deposit the first buffer layer 14A, and then the temperature of substrate 12 is raised to 1100°C to epitaxially grow the second buffer layer 14B. The temperature of the substrate 12 is then lowered to 800°C to form the InₓGa_{1 - x}N/GaN multiple quantum well structure 14C. Then, by transferring the substrate 12 into a vapor deposition apparatus and forming the conductive layer 18 on the multiple quantum well structure 14C, fabrication of the light-emitting body 10 is completed.

Note that, in the above-described example, trimethylgallium (Ga(CH₃)₃: TMGa) can be used as the Ga source, trimethylindium (In(CH₃)₃: TMIn) can be used as the In source, ammonia (NH₃) can be used as the N source, hydrogen gas (H₂) or nitrogen gas (N₂) can be used as the carrier gas, and monosilane (SiH₄) can be used as the Si source. Alternatively, other organometallic sources (e.g., triethylgallium (Ga(C₂H₅)₃: TEGa), triethylindium (In(C₂H₅)₃: TEIn), etc.) and other hydrides (e.g., disilane (Si₂H₄), etc.) may be used. Further, although the MOVPE apparatus is used in the above-described example, a hydride vapor phase epitaxy (HVPE) apparatus and a molecular beam epitaxy (MBE) apparatus may also be used. In addition, each growth temperature is not limited to the above-described temperatures.

In the present embodiment, the thickness of the well layers 141 is equal to or greater than 0.2 nm and less than 1.5 nm. As preferred, the thickness of the well layers 141 is equal to or greater than 0.6 nm and less than 1.0 nm. An additive to be added to the barrier layers 142 and the well layers 141 (hereinafter simply referred to as an "additive") include silicon. The concentration of the additive is greater than 4 × 10¹⁸ cm⁻³ and equal to or less than 1 × 10²⁰ cm⁻³. The additive is also referred to as a dopant, and the concentration of additive is also referred to as a Si doping concentration.

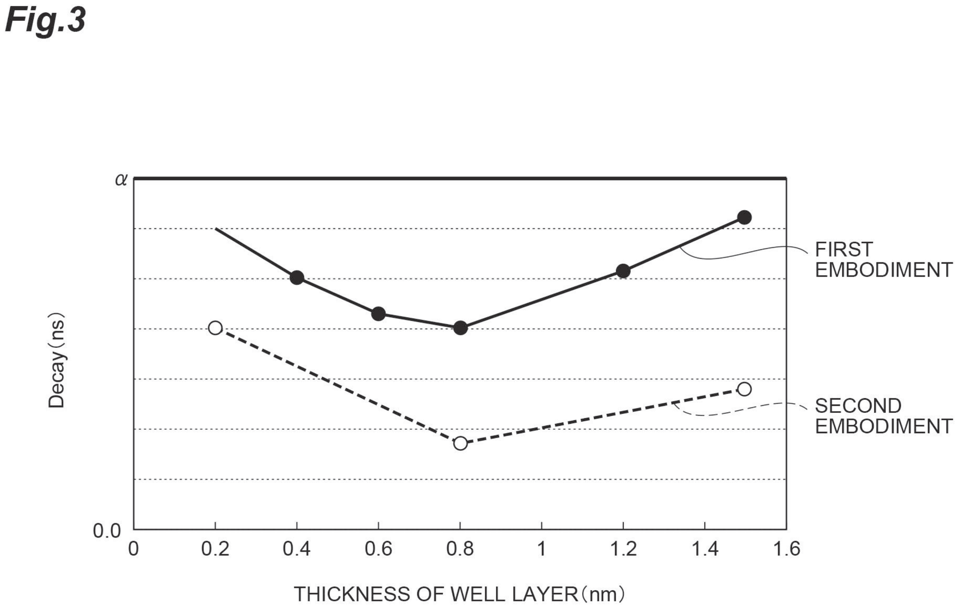

FIG. 3 is a graph showing the decay when the thickness of the well layers 141 in the light-emitting body 10 is varied. Decay refers to an afterglow time, defined as the time it takes for the peak intensity to decrease from 90% to 10%. In the graph, circles for the data indicate measured values, and line segments for the data indicate values obtained based on the measured values (the same in the following graphs). A first embodiment is about an example in which the concentration of the additive is 4 × 10¹⁸ cm⁻³. A second embodiment is about an example in which the concentration of the additive is 1.5 × 10¹⁹ cm⁻³. A threshold value α represents a value set based on the decay of a common light-emitting body, which is 3.5 ns in this case. The threshold value α is not particularly limited.

It is seen that the decay varies in a quadratic function-like manner with changes in the thickness of the well layers 141, as shown in FIG. 3. In the example shown in the figure, the quadratic function of the decay reaches the bottom when the thickness of the well layers 141 is in the range from 0.2 nm to 1.5 nm (in this case, around 0.8 nm). The correlation between the decay and the thickness of the well layers 141 is expected to exhibit a similar trend even when the concentration of the additive is changed. In the light-emitting body 10, the thickness of the well layers 141 being thinner than 0.2 nm is unrealistic from the manufacturing or practical viewpoints.

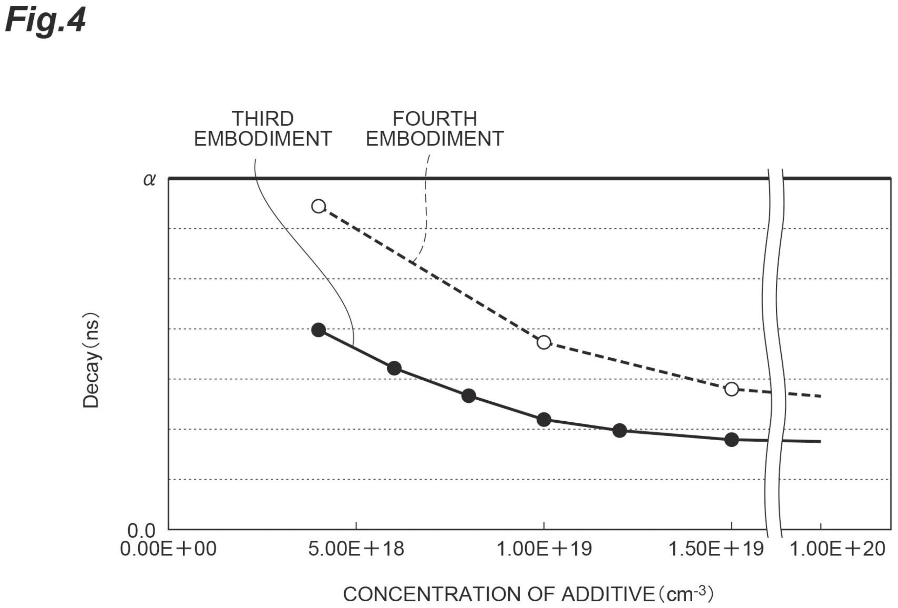

FIG. 4 is a graph showing the decay when the concentration of the additive in the light-emitting body 10 is varied. A third embodiment is about an example in which a thickness of the well layers 141 is 0.8 nm. A fourth embodiment is about an example in which a thickness of the well layers 141 is 1.5 nm. As shown in FIG. 4, the greater the concentration of the additive, the lower the decay. It can be seen that the amount of change in the decay becomes smaller as the concentration of the additive increases. The correlation between the decay and the concentration of additive is expected to exhibit a similar trend even when the thickness of the well layers 141 is changed. It can be seen that, if the concentration of the additive is less than 4 × 10¹⁸ cm⁻³, when the thickness of the well layers 141 is 1.5 nm, the possibility of the decay becoming larger and exceeding the threshold α increases.

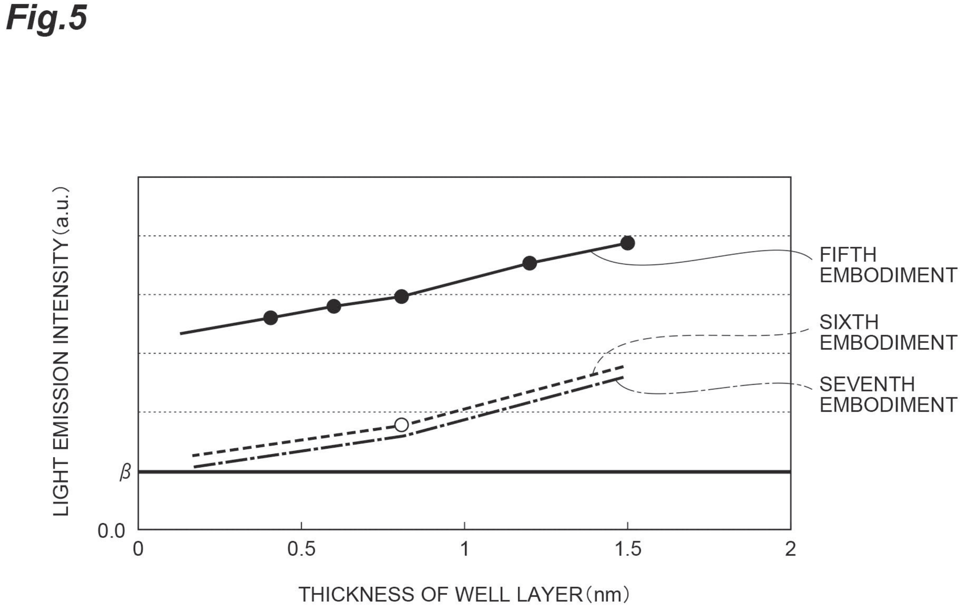

FIG. 5 is a graph showing the light emission intensity (arbitrary unit (a.u.)) when the thickness of the well layers 141 in the light-emitting body 10 is varied. A fifth embodiment is about an example in which the concentration of the additive is 4 × 10¹⁸ cm⁻³. A sixth embodiment is about an example in which the concentration of the additive is 1.5 × 10¹⁹ cm⁻³. A seventh embodiment is about an example in which the concentration of the additive is 1 × 10²⁰ cm⁻³. A threshold value β represents a value set based on the light emission intensity of a common light-emitting body, which is 5000 in this case. The threshold value β is not particularly limited.

As shown in FIG. 5, the greater the thickness of the well layers 141, the greater the light emission intensity. It is expected that the light emission intensity will exhibit a similar trend even if the concentration of the additive is changed. It can be seen that, if the thickness of the well layers 141 is less than 0.2 nm, when the concentration of the additive is, for example, 1 × 10²⁰ cm⁻³, the possibility of the light emission intensity becoming smaller and falling below the threshold value β increases.

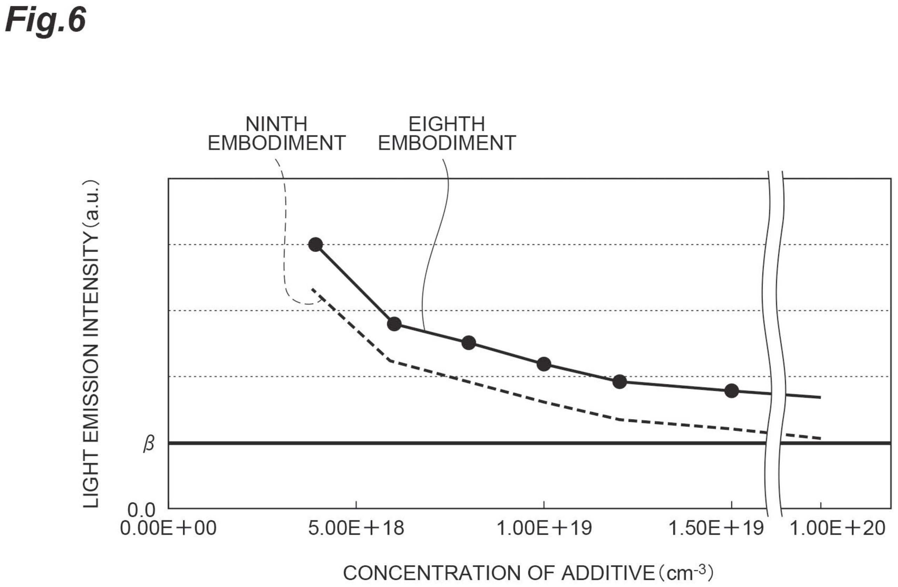

FIG. 6 is a graph showing the light emission intensity (arbitrary unit (a.u.)) when the concentration of the additive in the light-emitting body 10 is varied. An eighth embodiment is about an example in which a thickness of the well layers 141 is 0.8 nm. A ninth embodiment is about an example in which a thickness of the well layers 141 is 0.2 nm. As shown in FIG. 6, the greater the concentration of the additive, the lower the light emission intensity. The amount of change in the light emission intensity is smaller as the concentration of the additive increases. It is expected that, even if the thickness of the well layers 141 is changed, the light emission intensity will exhibit a similar trend. It can be seen that, if the concentration of the additive is higher than 1 × 10²⁰ cm⁻³, when the thickness of the well layers 141 is 0.2 nm, for example, the possibility of the light emission intensity becoming smaller and falling below the threshold β increases.

In the light-emitting body 10, the thickness of the well layers 141 is equal to or greater than 0.2 nm and less than 1.5 nm, and the concentration of the additive in the barrier layers 142 and the well layers 141 is higher than 4 × 10¹⁸ cm⁻³ and equal to or lower than 1 × 10²⁰ cm⁻³ as described above, In this case, the thickness of the well layers 141 and the concentration of additive in the barrier layers 142 and the well layers 141 can be optimized to lower the decay while maintaining the light emission intensity. Therefore, the response time can be further shortened and the high-speed responsiveness can be further enhanced.

In the light-emitting body 10, the thickness of the well layers 141 is equal to or greater than 0.6 nm and less than 1.0 nm. In this case, the decay can be further reduced.

In the light-emitting body 10, the multiple quantum well structure 14C consists of the first barrier layer and the second barrier layer as the barrier layers 142. The second barrier layer is positioned on the electron-incident surface 10a side with respect to the first barrier layer side, and the first barrier layer is thicker than the second barrier layer. Since the second barrier layer, which is relatively shallow from the electron-incident surface 10a, is relatively thin, the well layer 141, which is positioned on the side opposite to the electron-incident surface 10a across the second barrier layer, will be placed closer to the electron-incident surface 10a. Thus, it is possible to improve the light conversion efficiency for electron beams with low acceleration voltages. In addition, since the first barrier layer, which is positioned comparatively deep, is thicker, the well layer 141, which is positioned on the side opposite to the electron-incident surface 10a across the first barrier layer, will be placed far from the electron-incident surface 10a. Therefore, it is possible to maintain the light conversion efficiency even in deep penetration of electron beams with high acceleration voltages. Furthermore, since electron beams spread in a hemispherical shape inside the light-emitting body 10, the well wells that are densely placed near the electron-incident surface 10a reliably capture electrons even at high acceleration voltages. Then, by varying the thickness of the barrier layers 142 according to the distance from the electron-incident surface 10a as described above, the light conversion efficiency can be improved across a range of low to high acceleration voltages, thereby increasing the light emission intensity.

In light-emitting body 10, the well layers 141 and barrier layers 142 are nitride semiconductor layers, and the additive includes silicon. In this case, the well layers 141 and the barrier layers 142 are set to nitride semiconductor layers, and silicon can be used as the additive.

Note that, in the light-emitting body 10, the second barrier layer is the closest to the electron-incident surface 10a among the multiple barrier layers 142. Further, in that case, the second barrier layer is the thinnest among the multiple barrier layers 142. This allows the position of the well layer closest to the electron-incident surface 10a to be closer to the electron-incident surface 10a, further improving the light conversion efficiency for electron beams with low acceleration voltages.

In the light-emitting body 10, the thicknesses of the multiple barrier layers 142 increase with distance from the electron-incident surface 10a. In this case, an appropriate arrangement of the well layers can be achieved according to various magnitudes of acceleration voltage, further improving the light conversion efficiency. In the light-emitting body, the compositions of the multiple well layers 141 are identical to each other, which facilitates the fabrication of the multiple quantum well structure.

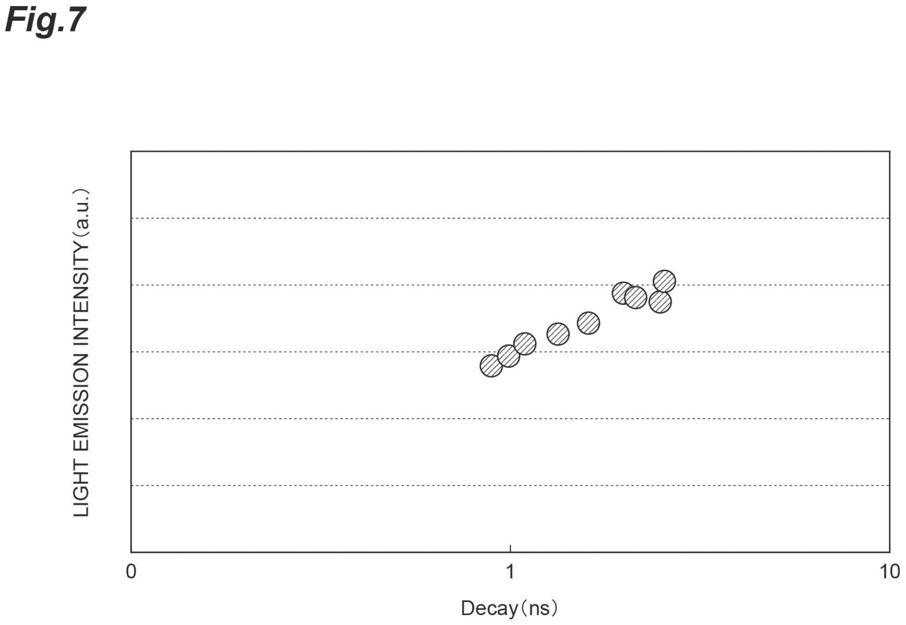

FIG. 7 is a graph showing a correlation between decay and light emission intensity in the light-emitting body 10. The figure represents each piece of data when the thickness of the well layers 141 and the concentration of the additive are varied. As shown in FIG. 7, it can be confirmed that the light-emitting body 10 has a correlation that a higher decay is associated with a higher light emission intensity.

Although incident electrons are converted into light in the present embodiment, the configuration is not limited to this. The present embodiment may be involved with any light-emitting body that converts incident charged particles into light. In the above-described embodiment, a nitride semiconductor refers to a compound containing at least one of Ga, In, or Al as a group III element and N as a major group V element. Having light transmittance means, for example, the property of transmitting more than 50% of target light.

### [Second Embodiment]

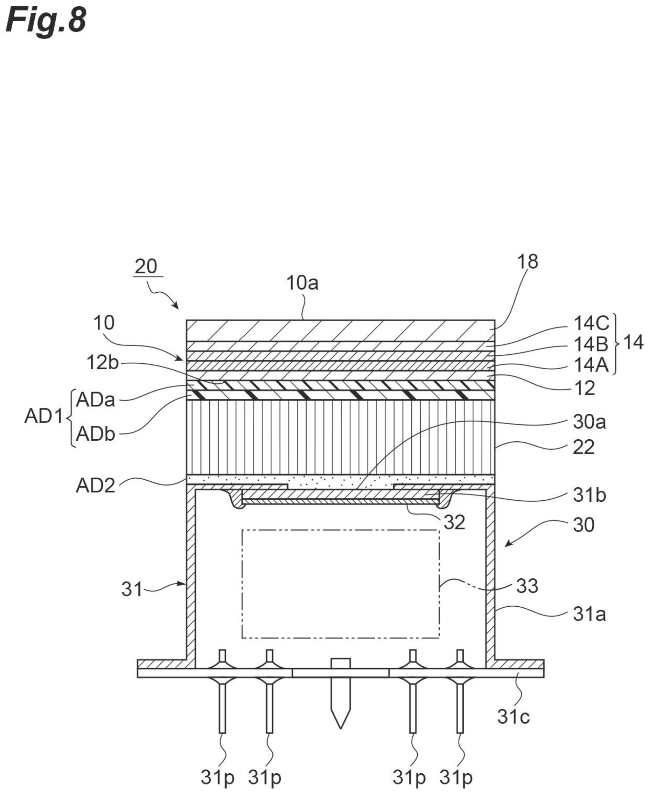

FIG. 8 is a cross-sectional view illustrating a configuration of an electron beam detector 20 according to a second embodiment, showing the cross-section extending along the thickness direction. As shown in FIG. 8, the electron beam detector 20 has the light-emitting body 10 of the first embodiment, an insulating optical member 22, and a photodetector 30. The optical member 22 is an example of a light-transmitting member (light guide member). The optical member 22 has insulating properties and is interposed between the light-emitting body 10 and the photodetector 30 to integrate the light-emitting body 10 and the photodetector 30.

A back surface 12b of the substrate 12 of the light-emitting body 10 and a light-incident surface 30a of the photodetector 30 are optically coupled through the optical member 22. Specifically, one end surface of the optical member 22 is bonded to the light-incident surface 30a, and the other end surface of the optical member 22 is bonded to the light-emitting body 10. The optical member 22 may be a light guide such as a fiber optic plate (FOP) or a lens that focuses the light generated in the light-emitting body 10 onto the light-incident surface 30a.

A light-transmissive adhesive layer AD2 is interposed between the optical member 22 and the photodetector 30, and the relative position between the optical member 22 and the photodetector 30 is fixed by the adhesive layer AD2. The adhesive layer AD2 mainly contains, for example, a light-transmissive resin. In addition, an adhesive layer AD1 is interposed between the back surface 12b of the substrate 12 of the light-emitting body 10 and the optical member 22. The adhesive layer AD1 contains a SiN layer ADa on the back surface 12b and a SiO₂ layer ADb on the SiN layer ADa. In one example, the back surface 12b and the SiN layer ADa are in contact with each other, and the SiN layer ADa and the SiO₂ layer ADb are in contact with each other. The SiO₂ layer ADb and the optical member 22 are fused to each other. Since the SiO₂ layer ADb and the optical member 22 are both silicon oxides, they can be fused together by heating.

Since the SiO₂ layer ADb is formed on the SiN layer ADa using the sputtering method, etc., the bonding strength of the SiN layer ADa and the SiO₂ layer ADb is extremely high. Similarly, since the SiN layer ADa is also formed on the back surface 12b of the substrate 12 using sputtering method, etc., the bonding strength of the SiN layer ADa and the substrate 12 is extremely high as well. Therefore, the substrate 12 and the optical member 22 are firmly bonded via the adhesive layer AD1. The SiN layer ADa also functions as an anti-reflection film, suppressing or reducing the reflection of light generated in the multiple quantum well structure 14C on the back surface 12b.

In the electron beam detector 20 having such a structure, light generated in the multiple quantum well structure 14C in response to incident electrons is sequentially transmitted through the adhesive layer AD1, the optical member 22, and the adhesive layer AD2 to the light-incident surface 30a of the photodetector 30.

The light-incident surface 30a of the photodetector 30 is optically coupled to the surface of the multiple quantum well structure 14C on the side opposite to the electron-incident surface 10a via the substrate 12, the adhesive layer AD1, the optical member 22, and the adhesive layer AD2, as described above. In other words, the photodetector 30 is optically coupled to the side of the multiple quantum well structure 14C opposite to the electron-incident surface 10a (see FIG. 1). The photodetector 30 is sensitive to light emitted by the multiple quantum well structure 14C. The photodetector 30 is, for example, a photomultiplier tube. In this case, the photodetector 30 includes a vacuum vessel 31. The vacuum vessel 31 consists of a metallic side tube 31a, a light-incident window 31b that closes the opening at the top of the side tube 31a, and a stem plate 31c that closes the opening at the bottom of the side tube 31a. Inside the vacuum vessel 31, a photocathode 32 formed on the inner surface of the light-incident window 31b and an electrode unit 33 including an electron multiplier and an anode are arranged. The electron multiplier includes, for example, a microchannel plate or a mesh-type dynode.

The light-incident surface 30a is the outer surface of the light-incident window 31b, and light incident on the light-incident surface 30a is transmitted through the light-incident window 31b and incident on the photocathode 32. The photocathode 32 performs a photoelectric conversion in response to light incidence and emits the generated photoelectrons into the interior space of the vacuum vessel 31. These photoelectrons are multiplied by the electron multiplier in the electrode unit 33. The multiplied electrons are collected at the anode of the electrode unit 33. The electrons collected at the anode of the electrode unit 33 are extracted to the outside of the photodetector 30 through any of multiple pins that penetrate the stem plate 31c. The potential of the metallic side tube 31a is 0 V, and the photocathode 32 is electrically connected to the side tube 31a.

In the above, the electron beam detector 20 can similarly improve the high-speed responsiveness by being equipped with the light-emitting body 10. Note that, although the present embodiment is about the electron beam detector 20 that receives incidence of electrons, the invention is not limited to this, and it can be a charged particle detector that receives incidence of charged particles.

### [Third Embodiment]

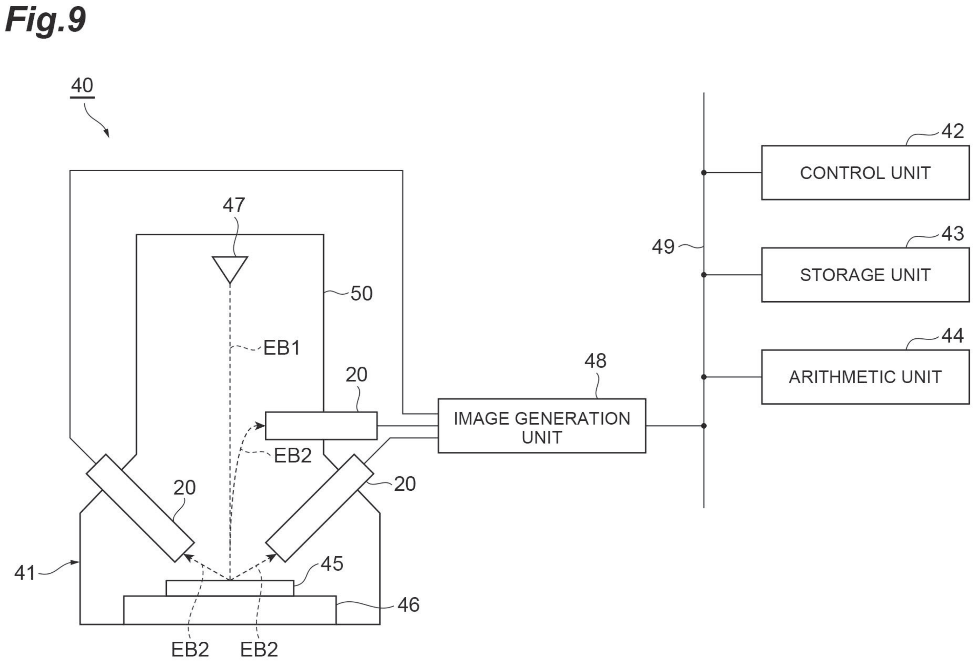

The electron beam detector 20 of the second embodiment (see FIG. 8) can be used in an electron microscope, for example, a scanning electron microscope (SEM). FIG. 9 is a view schematically illustrating a configuration of a metrology SEM 40 according to a third embodiment. The metrology SEM 40 includes an SEM 41 that acquires images of a target to be inspected, a control unit 42 that performs overall control, a storage unit 43 that stores acquired images and the like on a magnetic disk, a semiconductor memory, or the like, and an arithmetic unit 44 that performs arithmetic operations according to a program.

The SEM 41 includes a movable stage 46 on which a sample wafer 45 is mounted, an electron source 47 that irradiates an electron beam EB1 onto the sample wafer 45, and multiple (three in the figure as an example) electron beam detectors 20 that detect electrons (secondary electrons and reflected electrons) generated from the sample wafer 45. The electron beam detector 20 has the same configuration as that of the second embodiment. The SEM 41 includes an electron lens (not shown) that focuses the electron beam EB1 onto the sample wafer 45, a deflector (not shown) to scan the electron beam EB1 onto the sample wafer 45, and an image generator 48 that digitally converts signals from each of the electron beam detector 20 to generate a digital image.

The metrology SEM 40 includes a vacuum chamber (chamber) 50 whose interior space is a vacuum (reduced pressure) atmosphere. The movable stage 46, the electron source 47, at least the light-emitting body 10 of the electron beam detector 20, the electron lens, and the deflector are arranged inside the vacuum chamber 50. The image generator 48 and each of the electron beam detectors 20 are electrically connected to each other via wiring. The image generator 48, the control unit 42, the storage unit 43, and the arithmetic unit 44 are electrically connected to each other via a data bus 49.

When the electron beam EB1 is scanned on the surface of the sample wafer 45 while irradiating the sample wafer 45 with the electron beam EB1, electrons are emitted from the surface of the sample wafer 45, which are directed to the electron beam detectors 20 as electron beams EB2. The electron beam detectors 20 convert the electron beams EB2 into electrical signals, and the electrical signals are output according to the amount of current in the electron beams EB2. By synchronizing and associating the scanning position of the electron beam EB1 with the output of the electron beam detectors 20, an image of the sample wafer 45 can be acquired.

The control unit 42 has functions to control transport of the sample wafer 45, to control the movable stage 46, to control the irradiation position of the electron beam EB1, and to control the scanning of the electron beam EB1. The storage unit 43 has an area for storing acquired image data and an area for storing imaging conditions (e.g., acceleration voltages, etc.). The arithmetic unit 44 has the function of calculating the dimensions of a configuration (such as a groove width) based on the shading (contrast) in the image data. Note that the control unit 42 and the arithmetic unit 44 may be configured as hardware designed to realize each function, or may be configured to be implemented as software and executed using a general-purpose arithmetic device (e.g., CPU or GPU).

In the above, the metrology SEM 40 can similarly improve the high-speed responsiveness by including the light-emitting body 10.

### [Fourth Embodiment]

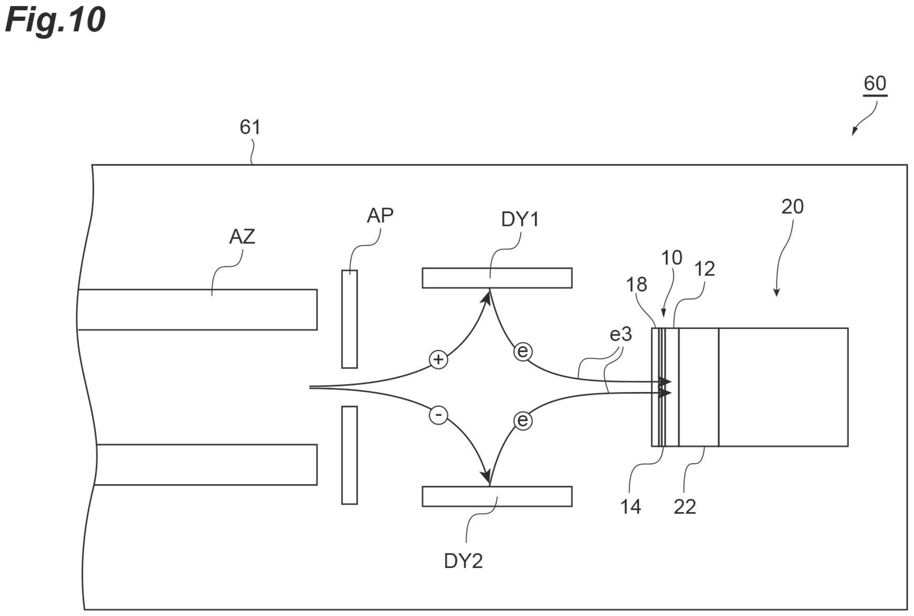

The electron beam detector 20 of the second embodiment (see FIG. 8) can be used in a mass spectrometer. FIG. 10 is a view schematically illustrating a configuration of a mass spectrometer 60 according to a fourth embodiment. As illustrated in FIG. 10, the mass spectrometer 60 has an electron beam detector 20 (see FIG. 8), which has the same configuration as the second embodiment, a vacuum chamber (chamber) 61 in which at least the light-emitting body 10 (Figure) of the electron beam detector 20 is arranged in an internal space that is in a vacuum (reduced pressure) atmosphere, a separation unit AZ that separates ions generated from the sample inside the vacuum chamber 61 spatially or temporally according to their mass, and dynodes DY1 and DY2 which are electron converters irradiated with the ions separated in the separation unit AZ.

In the mass spectrometer 60, electrons emitted from the dynodes DY1 and DY2 in response to the incidence of ions to the dynodes DY1 and DY2 are directed to the light-emitting body 10, and mass analysis of the sample is performed based on the output of the electron beam detector 20. Specifically, in the mass spectrometer 60, by applying an appropriate potential to an aperture AP and a negative potential to the dynode DY1 positioned opposite to the separation unit AZ with respect to the aperture AP, the positive ions positioned inside the separation unit AZ pass through the aperture AP and collide with the dynode DY1, and as a result of the collision, electrons are emitted from the surface of the dynode DY1, and directed as an electron beam e3 to the electron beam detector 20. When a positive potential is applied to the dynode DY2 and negative ions are drawn from the separation unit AZ, these negative ions collide with the dynode DY2, and as a result of the collision, electrons are emitted from the surface of the dynode DY2, which are directed as an electron beam e3 to the electron beam detector 20. An electrical signal is output from the electron beam detector 20 in response to the incidence of the electron beams e3.

For example, if the separation unit AZ is a flight tube, the ions pass through the inside of the flight tube in different times depending on their mass, and therefore arrive at the dynodes DY1 and DY2 at different times. In addition, for example, if the separation unit AZ uses a magnetic field to alter the flight trajectory of the ions according to their mass, by varying the magnetic flux density of the separation unit AZ, the mass of the ions passing through the aperture AP will differ. Therefore, the mass of the ions can be determined by monitoring the temporal change in the electrical signal output from the electron beam detector 20.

In the above, the mass spectrometer 60 can similarly improve the high-speed responsiveness further by including the light-emitting body 10.

### [Modification Examples]

One aspect of the present invention is not limited to the above embodiments, and other variations are possible.

In the above embodiments, the composition of the well layers 141 and barrier layers 142 comprising the multiple quantum well structure 14C is not limited to the examples described above. Although the first buffer layer 14A and the second buffer layer 14B are exemplified as GaN layers in the above example, if they are a nitride semiconductor that contains at least one or more of In, Al, and Ga as group III elements, N as a major group V element, and has light transmittance for the light emission wavelength of the multiple quantum well structure 14C, other compositions may be applied.

Although, the above embodiments show an example in which Si is doped in the well layers 141 and the barrier layers 142 of the multiple quantum well structure 14C, they are not limited thereto and other impurities (e.g., Mg) can be doped. In the above embodiments, the well layers 141 and the barrier layers 142 of the multiple quantum well structure 14C can be composed of InₓAl_{y}Ga_{l - x - y}N (0 ≤ x ≤ 1, 0 ≤ y ≤ 1, 0 ≤ x + y ≤ 1). Thus, in addition to the InGaN/GaN combination described above, other combinations, for example, InGaN/AlGaN, InGaN/InGaN, GaN/AlGaN, etc., are possible. Alternatively, the well layers 141 and the barrier layers 142 may be composed of other semiconductors other than nitride semiconductors.

Although the number of layers for the well layers 141 and the barrier layers 142 is nine each in the above-described embodiments, the number of layers for the well layers 141 and the barrier layers 142 can be any number greater than 2. Although the photodetector 30 is limited to a photomultiplier tube in the above-described embodiments, it may be an avalanche photodiode. In addition, the optical member 22 is not limited to a straight shape and can also be curved, and its size can be adjusted as appropriate.

Although the multiple quantum well structure 14C is a structure in which the first barrier layer on the substrate 12 side is thicker than the second barrier layer on the electron-incident surface 10a side (which is a so-called gradient-type structure) in the above-described embodiments, the invention is not particularly limited, and the thicknesses of the multiple barrier layers 142 may be equal to or different from each other.

Each of the above numerical values may include errors in measurement, manufacturing, and design. The above "4 × 10¹⁸ cm⁻³" includes not only exactly 4 × 10¹⁸ cm⁻³ but also substantially 4 × 10¹⁸ cm⁻³. The above "1 × 10²⁰ cm⁻³" includes not only exactly 1 × 10²⁰ cm⁻³ but also substantially 1 × 10²⁰ cm⁻³. The above "0.6 nm" includes not only exactly 0.6 nm but also substantially 0.6 nm. The above "1.0 nm" includes not only exactly 1.0 nm but also substantially 1.0 nm. The terms "measurement", "manufacturing", and "design" in the above description can be performed in compliance with known standards and specifications, such as JIS, for example. The terms "equal" and "same" in the above description include not only the cases of being exactly equal and exactly the same, but also the cases of being substantially equal and substantially the same.

### Reference Signs List

10: Light-emitting body, 10a: Electron-incident surface (charged particle-incident surface), 12: Substrate, 12a: Main surface, 12b: Back surface, 14: Nitride semiconductor layer, 14A: First buffer layer, 14B: Second buffer layer, 14C: Multiple quantum well structure, 18: Conductive layer, 20: Electron beam detector, 22: Optical member, 30: Photodetector, 30a: Light-incident surface, 31: Vacuum vessel, 32: Photocathode, 33: Electrode unit, 40: Metrology SEM, 41: Scanning electron microscope (SEM), 42: Control unit, 43: Storage unit, 44: Arithmetic unit, 45: Sample wafer, 46: Movable stage, 47: Electron source, 48: Image generator, 50, 61: Vacuum chamber (chamber), 141: Well layer, 142, 143: Barrier layer, AZ: Separation unit, DY1, DY2: Dynode (electron converter).

## Claims

1. A light-emitting body that converts incident charged particles into light, the light-emitting body comprising:
a multiple quantum well structure for emitting the light upon incidence of the charged particles,
wherein a thickness of a well layer constituting the multiple quantum well structure is equal to or greater than 0.2 nm and less than 1.5 nm, and
a concentration of an additive added in a barrier layer and the well layer constituting the multiple quantum well structure is higher than 4 × 10¹⁸ cm⁻³ and equal to or lower than 1 × 10²⁰ cm⁻³.

2. The light-emitting body according to claim 1, wherein the thickness of the well layer is equal to or greater than 0.6 nm and less than 1.0 nm.

3. The light-emitting body according to claim 1 or 2,
wherein the multiple quantum well structure is configured to include a first barrier layer and a second barrier layer as the barrier layers,
the second barrier layer is positioned on a charged particle-incident surface side of the multiple quantum well structure with respect to the first barrier layer, and
the first barrier layer is thicker than the second barrier layer.

4. The light-emitting body according to claim 1 or 2, wherein the well layer and the barrier layer are nitride semiconductor layers, and
the additive includes silicon.

5. A charged particle detector comprising:
the light-emitting body according to claim 1 or 2; and
a photodetector that is optically coupled to the side opposite to a charged particle-incident surface in the multiple quantum well structure and sensitive to the light emitted by the multiple quantum well structure.

6. An electron microscope comprising:
the light-emitting body according to claim 1 or 2;
a photodetector that is optically coupled to the side opposite to a charged particle-incident surface in the multiple quantum well structure and sensitive to the light emitted by the multiple quantum well structure; and
a chamber in which at least the light-emitting body is placed, wherein a surface of a sample placed in the chamber is irradiated with an electron beam, electrons from the sample are directed to the light-emitting body, and an image of the sample is acquired by associating the irradiation position of the electron beam on the sample with an output of the photodetector.

7. A mass spectrometer comprising:
the light-emitting body according to claim 1 or 2;
a photodetector that is optically coupled to the side opposite to a charged particle-incident surface in the multiple quantum well structure and sensitive to the light emitted by the multiple quantum well structure; a chamber in which at least the light-emitting body is placed;
a separation unit that spatially or temporally separates ions generated from the sample in the chamber according to their mass; and
an electron converter irradiated with ions separated by the separation unit,
wherein electrons emitted from the electron converter are directed to the light-emitting body in response to incidence of ions to the electron converter, and mass analysis of the sample is performed based on an output of the photodetector.
